# EUROPEAN PATENT APPLICATION

(11) **EP 1 903 658 A2**
(43) Date of publication of application: **26.03.2008**
(21) Application number: 07116028.7
(22) Date of filing: 10.09.2007
(51) Int. Cl.: H02J 7/00

(54) **Battery indicator**

(30) Priority: 11.09.2006 SE 0601868
(71) Applicant: Creator Teknisk Utveckling AB, 776 70 Vikmanshyttan (SE)
(72) Inventor: Maleus, Börje, 176 74, Järfälla (SE); Löfgren, Pierre, 784 54, Borlänge (SE)
(74) Representative: Holmberg, Nils Anders Patrik

(57) **Abstract**

The present invention relates to a device for battery, comprising a housing (10), an electronic circuit arranged in the housing, cables connected to the circuit and arranged to be connected to a battery, that the circuit is capable of detecting the voltage of a connected battery, and an indicator (16) connected to the circuit, whereby, when the circuit detects that the voltage of the battery has decreased below a certain level, the indicator is activated.

## Description

### TECHNICAL AREA

The present invention relates to a device for indicating the charging status of a battery and in particular for vehicles that are parked for longer periods.

### TECHNICAL BACKGROUND

In for example car dealers, cars can be parked for long periods without being driven and without charge. A modern car with a lot of loads on the battery cannot cope with this very well, but needs to be charged regularly in order to maintain a reasonable battery capacity when the car eventually is to be started and to be used. It is however difficult to monitor the charging status of cars that are parked for long periods of time. The consequence is that maintenance charging is either done with a large work effort, by measuring the voltage of every car, or more randomly. A car that does not start when a potential customer is to test drive the car often means that there is no deal or a promise of a new battery.

The same problem can occur on for example a car with a liftgate and a separate battery. A simple battery guard can prevent the battery voltage from decreasing too low, which otherwise would lead to negative consequences regarding performance and in some instances damage on components.

### BRIEF DESCRIPTION OF THE INVENTION

The aim of the present invention is to provide a simple, robust and reliable device for indicating battery status.

According to a main aspect of the present invention this is characterised by a device for a battery comprising a housing, an electric circuit arranged in the housing, cables attached to the circuit and arranged to be capable of being connected to a battery, that the circuit is capable of detecting the voltage of a connected battery, and an indicator connected to the circuit, whereby, when the circuit detects that the voltage of the battery has decreased below a certain level, activating the indicator.

According to another aspect of the invention, it is characterised in that the indicator is at least a light source. The indicator can also be several light sources where each individual light source is related to a certain voltage level, and activated when the circuit detects this voltage level. The indicator can also be a sound source.

According to yet an aspect of the invention it is characterised in that it further comprises connection means for a battery charger. Preferably the connection means are a quick connection.

According to a further aspect of the invention it is characterised by a holding device designed for releasable connection to for example a vehicle containing the battery, which holding device may be a suction cup or a magnet.

The device according to the invention displays a number of advantages. Due to the simple connection of the device on for example a vehicle with the help of the holding device as well as the simple connection to the battery of a vehicle, a very simple and robust battery indicator is obtained, where the or those persons responsible for a fleet of cars, such as a car dealer, very quickly has an overview of the battery status of the vehicles. The device can also easily be mounted and removed, i.e. moved between different vehicles thanks to the battery connection and the holding device permitting a simple releasable mounting.

Because the device preferably is arranged with a connection for a battery charger, also preferably a quick connection, it is a simple task to connect a battery charger when the indicator indicates that the voltage has decreased below an acceptable level. If further a number of indicators are used, where each indicator is related to a certain voltage level, it is possible to obtain a status picture of the condition of the batteries as well as future needs for charging.

These and other aspects of and advantages with the present invention will become apparent from the following detailed description and from the accompanying drawings.

### BRIEF DESCRIPTION OF THE DRAWINGS

In the following detailed description of the invention, reference will be made to the accompanying drawings, of which
- Fig. 1: shows schematically an embodiment of the present invention,
- Fig. 2: shows an example of the use of the present invention, and
- Fig. 3: shows another example of use.

### DETAILED DESCRIPTION OF THE INVENTION

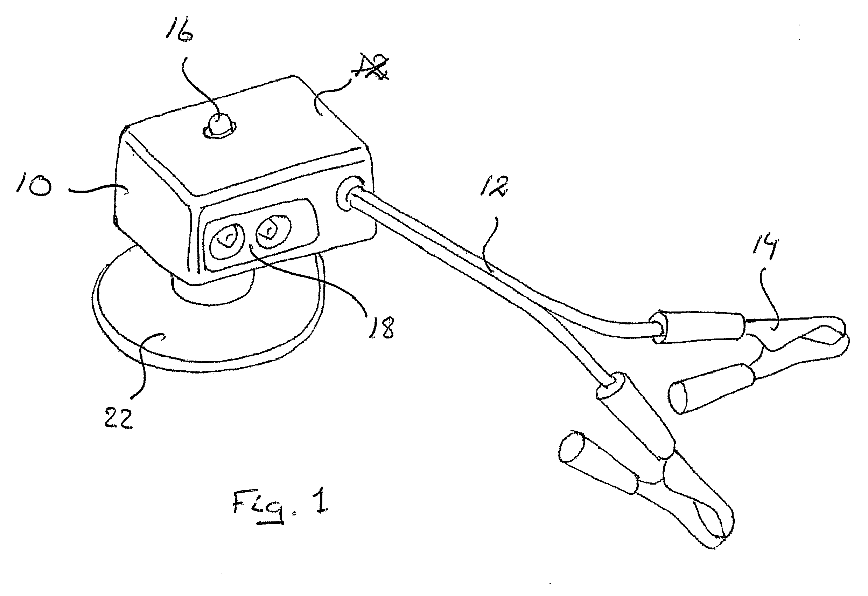

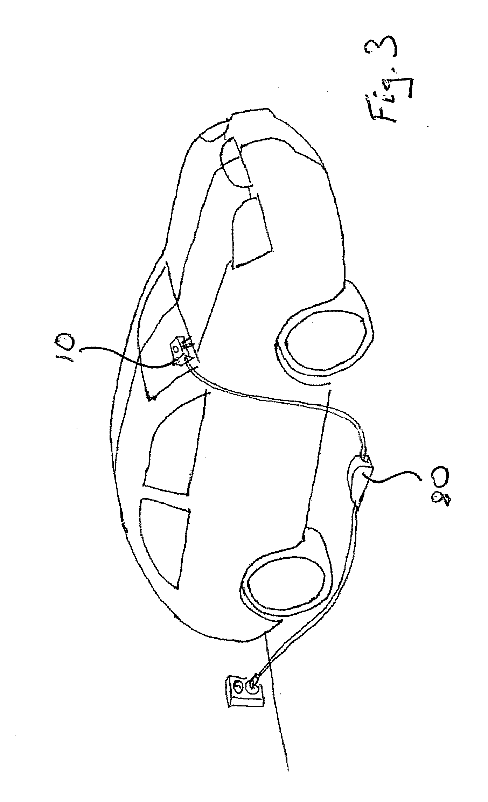

Figure 1 shows a feasible embodiment of the present invention. It comprises a housing 10, in the inner of which connections for electric cables are arranged (not shown). A two-lead cable 12 is attached to the connections. The other end is arranged with battery clips 14. The battery cable is preferably so robust it may go through the sealing of a hood. To the connections in the housing a circuit is arranged (not shown), which is designed and arranged such that it is capable of detecting the voltage over the battery poles of a battery connected to the clips. To the circuit is further at least one indicator 16 connected which may be a lamp, light emitting diode, summer or the like and/or combinations of these. Further preferably a connection device 18 is arranged in the housing and connected to the circuit, which connection device is intended to receive a charge plug from an external battery charger 20, Fig. 3.

To the housing is also a holding device 22 arranged, such as a suction cup to being attached to the wind screen on a discrete place such as the lower corner, or a magnet so that it may be attached to the car body.

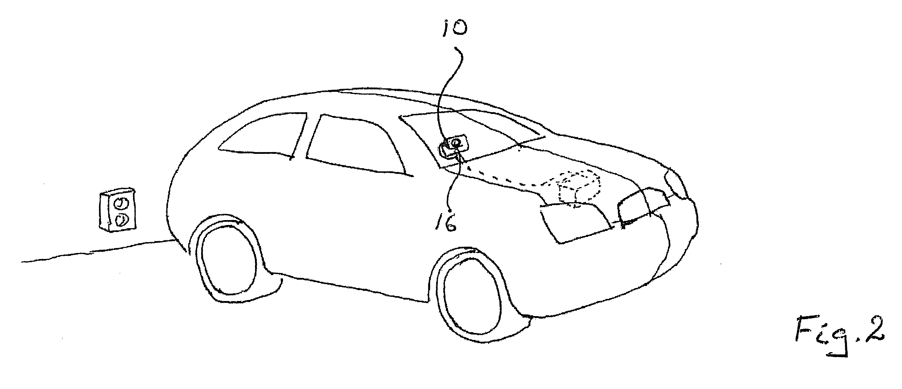

The device is intended to function as follows. The device 10 is attached to the vehicle with the aid of the holding device 22, for example on the wind screen with the aid of the suction cup, Fig. 2, or to the body with the aid of the magnet. After this the battery clips 14 are connected to the battery of the vehicle. The hood of the car can then be closed and the cables run through its seal. The circuit of the device will now continuously monitor the voltage over the poles of the battery.

If the voltage over the battery decreases below a certain voltage level, it is detected by the circuit, whereby it sends a signal to the indicator 16, which is activated. It may thus be that a light source is lit or that a summer signal is emitted. The device can also be equipped with several light sources, which are arranged to the circuit to indicate different voltage levels. Thus, for example a green light source may be lit when the voltage is on a normal level, a yellow light source may be lit when the voltage has decreased below a certain level but does not be charged yet, and a red light source may be lit when the battery needs to be charged.

With the device according to the invention, it is thus very simple for the personnel of for example a car dealer to monitor the status of the batteries of the cars by merely looking at the indicator. Because the device preferably is arranged with a connection device 18, preferably a quick connection, for connecting a battery charger, it is easy for the personnel to connect a charger, Fig. 3, when the indicator indicates that the voltage level in the battery is so low that it needs to be charged.

When someone for example wants to test drive a vehicle, it is very simple to remove the device from the vehicle by merely disconnecting the battery clips and remove the device from the surface of the vehicle. Then the device may be readily connected to another vehicle.

It is to be understood that the embodiment described above and shown in the drawings only is a non-limiting example of the invention and that it is defined by the scope of protection of the patent claims.

## Claims

1. Device for battery, comprising a housing, an electronic circuit arranged in the housing, cables connected to the circuit and arranged to be connected to a battery, that the circuit is capable of detecting the voltage of a connected battery, and an indicator connected to the circuit, whereby, when the circuit detects that the voltage of the battery has decreased below a certain level, the indicator is activated.

2. Device according to claim 1, **characterised in that** the indicator is at least a light source.

3. Device according to claim 2, **characterised in that** the indicator is several light sources where each individual light source is related to a certain voltage level, and activated when the circuit detects this voltage level.

4. Device according to any of the preceding claims, **characterised in that** the indicator is a sound source.

5. Device according to any of the preceding claims, **characterised in that** it further comprises connection means for a battery charger.

6. Device according to claim 5, **characterised in that** the connection means is a quick coupling.

7. Device according to any of the preceding claims, **characterised in that** it further comprises a holding device designed for releasable connection to for example a vehicle comprising the battery.

8. Device according to claim 7, **characterised in that** the holding device is a suction cup.

9. Device according to claim 7, **characterised in that** the holding device is a magnet.
